# EUROPEAN PATENT APPLICATION

(11) **EP 4 075 932 A1**
(43) Date of publication of application: **19.10.2022**
(21) Application number: 20898515.0
(22) Date of filing: 12.11.2020
(51) Int. Cl.: H05K 7/20, H02M 7/06, H02M 7/48

(54) **POWER CONVERSION DEVICE**

(30) Priority: 13.12.2019 JP 2019225593
(71) Applicant: HITACHI INDUSTRIAL EQUIPMENT SYSTEMS CO., LTD., Tokyo 101-0022 (JP)
(72) Inventor: MATSUMOTO Daisuke, Tokyo 101-0022 (JP); TANABE Keisuke, Tokyo 101-0022 (JP); HAMANO Koji, Tokyo 101-0022 (JP); TOMIYAMA Kiyotaka, Tokyo 101-0022 (JP)
(74) Representative: MERH-IP Matias Erny Reichl Hoffmann Patentanwälte PartG mbB
(86) International application number: PCT/JP2020/042326
(87) International publication number: WO 2021/117413

(57) **Abstract**

A power conversion device includes: an inverter circuit that converts direct-current electric power into alternating-current electric power; a heat sink that cools the inverter circuit; an inrush prevention circuit that suppresses inrush current; a smoothing circuit that smooths voltage; a first board on which the inverter circuit is arranged; a second board on which the smoothing circuit and the inrush prevention circuit are arranged; a main unit case that accommodates the heat sink, the inrush prevention circuit, and the smoothing circuit; and a fan that blows cooling air from the inrush prevention circuit and the smoothing circuit toward the heat sink within the main unit case.

## Description

### TECHNICAL FIELD

The present invention relates to a power conversion device.

### BACKGROUND ART

A power conversion device has been widely adopted in industry as a speed control device for an electric motor.

In Patent Document 1, a power conversion device including a rectifier, a transformation unit, a smoothing capacitor, and an inverter circuit is disclosed in which a first board on which a power module with the built-in inverter circuit is mounted, and a second board on which the smoothing capacitor and a relay are mounted are connected to each other by two copper bars having both of a heat release function and an electric conduction function.

### CITATION LIST

### PATENT DOCUMENT

Patent Document 1: WO 2014/106894

### SUMMARY OF THE INVENTION

### PROBLEMS TO BE SOLVED BY THE INVENTION

In order to protect a rectification diode configuring a forward converter from a large charging current to an electrolytic capacitor, an inrush prevention circuit is provided in the power conversion device. In such an inrush prevention circuit, a resistance for suppressing a current is provided, and a switching element such as a relay or a thyristor is connected to the resistance in parallel. When a power source is turned on, the charging current to the electrolytic capacitor is suppressed by the resistance, and the relay is turned on in the vicinity where the capacity of the electrolytic capacitor is maximally charged.

After the relay is turned on, almost all currents flow to the relay. A resistance component is parasitized within the relay, and thus, heat is generated when a current flows. A rectification diode or an insulated gate bipolar transistor (IGBT) configuring a forward converter and a reverse converter include the resistance component, and a Joule loss accounting for a large percentage of the entire device occurs as a main current of the power conversion device flows. Due to such a Joule loss, a desired power conversion function is not capable of being maintained unless heat release is performed by suitable means.

In Patent Document 1, a structure of alleviating heat interference between the first board and the second board with two copper bars is disclosed, but effectively cooling the inrush prevention circuit, the smoothing circuit including the capacitor, and the inverter circuit is not sufficiently considered.

An object of the present invention is to provide a power conversion device in which an inrush prevention circuit, a smoothing circuit, and an inverter circuit are effectively cooled.

### SOLUTIONS TO PROBLEMS

A preferred example of the present invention is a power conversion device, including: an inverter circuit converting direct-current electric power into alternating-current electric power; a heat sink cooling the inverter circuit; an inrush prevention circuit suppressing an inrush current; a smoothing circuit smoothing a voltage; a first board on which the inverter circuit is arranged; a second board on which the smoothing circuit and the inrush prevention circuit are arranged; a main unit case accommodating the heat sink, the inrush prevention circuit, and the smoothing circuit; and a fan blowing cooling air from the inrush prevention circuit and the smoothing circuit toward the heat sink within the main unit case.

### EFFECTS OF THE INVENTION

According to the present invention, an inrush prevention circuit, a smoothing circuit, and an inverter circuit can be effectively cooled.

### BRIEF DESCRIPTION OF THE DRAWINGS

Fig. 1 is a circuit diagram illustrating a power conversion device of Example 1.
Fig. 2 is an exploded view of the power conversion device of Example 1.
Fig. 3 is an internal configuration diagram when the power conversion device is seen from a lateral surface.
Fig. 4 is a diagram illustrating a connection relationship between a first PCB board and a second PCB board of the power conversion device.
Fig. 5 is a circuit diagram illustrating a case in which a reactor is connected to a collective terminal block as an external additional circuit.
Fig. 6 is a circuit diagram illustrating a case in which an external direct-current power source is connected to the collective terminal block.

### MODE FOR CARRYING OUT THE INVENTION

Hereinafter, Example will be described with reference to the drawings.

### Example 1

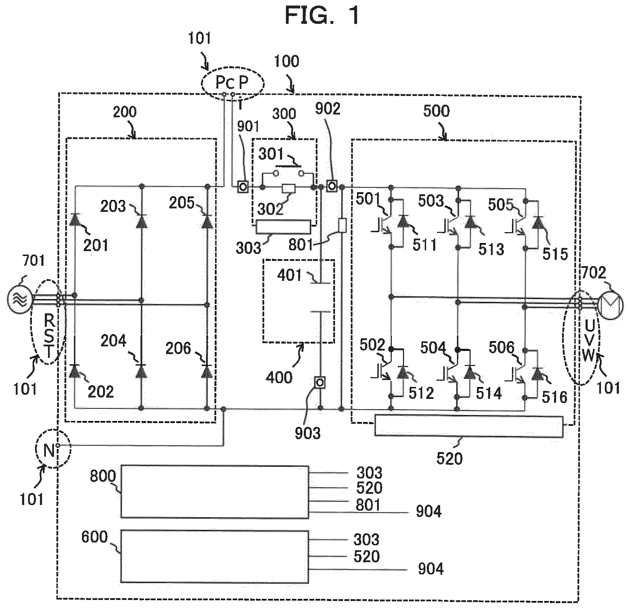

Fig. 1 is a circuit diagram illustrating a power conversion device of Example 1, and a power conversion device 100 will be described with reference to Fig. 1. The power conversion device 100 in Fig. 1 includes a converter circuit 200, an inrush prevention circuit 300, a smoothing circuit 400, and an inverter circuit 500. The converter circuit 200 configures a three-phase full-wave rectification circuit of six diodes (rectifier elements) 201 to 206.

The converter circuit converts an alternating-current voltage of a three-phase alternating-current power source 701 into a direct-current voltage of approximately 1.35 times a line voltage. In the converted direct-current voltage, a pulsation of 6 times the frequency of the three-phase alternating-current power source 701 is superimposed. The smoothing circuit 400 including a capacitor 401 decreases the amplitude of the pulsation of the voltage to be smooth.

When the converter circuit 200 starts receiving power, a relay 301 of the inrush prevention circuit 300 is in an OFF state, and thus, the capacitor 401 is charged through a current-limiting resistance 302 connected to the relay 301 in parallel. The direct-current voltage increases as the capacitor 401 is charged.

A control circuit 800 monitors the direct-current voltage with a voltage sensor 801, and the control circuit 800 transmits a drive signal to a relay drive circuit 303 after the direct-current voltage exceeds a predetermined value and turns on the relay 301.

Since a parasitize resistance of the relay 301 is smaller than the current-limiting resistance 302, almost all currents flow through the relay 301. A procedure until the current flows through the relay 301 is referred to as initial charging.

The inverter circuit 500 is a circuit converting direct-current electric power stored in the capacitor 401 into alternating-current electric power. One switching element 501 and one rectifier element 511 are connected to each other in anti-parallel to configure a circuit, and such a circuit is referred to as an arm. The other five switching elements 502 to 506 and the other five rectifier elements 512 to 516 configure five arms.

The inverter circuit 500 configures six arms as a bridge. A load 702 such as a motor is connected to the inverter circuit 500. The control circuit 800 calculates a control signal according to a desired output frequency and transmits the control signal to an inverter drive circuit 520, and the switching of the switching elements 501 to 506 in the inverter circuit 500 is controlled based on the drive signal of the inverter drive circuit 520.

According to the operation described above, the direct-current electric power stored in the capacitor 401 is converted into power. While the power is discharged from the capacitor 401 in accordance with the operation of the inverter circuit 500, the power is continuously supplied to the capacitor 401 through the three-phase alternating-current power source 701, the converter circuit 200, and the relay 301.

As described above, when the power conversion device 100 is in an operating state, a current flows to the converter circuit 200, the relay 301, and the inverter circuit 500, and a Joule loss occurs due to a parasitize resistance component. In a case where the temperature of the rectifier elements 201 to 206 and 511 to 516, and the switching elements 501 to 506 of the converter circuit 200 and the inverter circuit 500 exceeds a predetermined temperature, rectification properties and switching properties thereof are lost, and a failure occurs in which desired power conversion is not capable of being performed. Even in a case where such a failure does not occur, the lifetime is degraded due to repeated use at a high temperature, and thus, it is necessary to suppress an increase in a temperature according to the lifetime expected for the power conversion device 100.

In the capacitor 401, charge and discharge are repeated, and the Joule loss occurs due to the parasitize resistance component within the capacitor 401. In a case where the temperature within the capacitor 401 excessively increases due to the Joule loss, a failure in which an internal pressure of the capacitor 401 increases to rupture the capacitor 401, and the degradation of the lifetime of an organic material configuring the capacitor 401 are accelerated. Accordingly, it is necessary to suppress an increase in the temperature of the capacitor 401 according to the lifetime expected for the power conversion device 100.

In a case where the temperature of the relay 301 exceeds a predetermined temperature, an opening and closing force of a built-in coil is weakened, and switching properties are degraded, and thus, it is necessary to suppress an increase in the temperature in order to ensure a sounder operation. There is a case where a plurality of relays 301 are configured in parallel to increase output capacity of the power conversion device.

However, in such a configuration where the plurality of relays 301 are connected to each other in parallel, self-generated heat of each of the relays interferes with each other, and thus, the ambient temperature increases compared to a case where the relay 301 is used alone. As a result thereof, a current that is capable of flowing per one relay is limited, and a relay having likelihood is selected, and thus, a freedom degree is limited.

The self-generated heat of the control circuit 800, the relay drive circuit 303, the inverter drive circuit 520, and the power source circuit 600 is small, and in general, can be self-cooled. However, a problem may occur due to heat interference in a case where a component having large self-generated heat is arranged in the vicinity. Accordingly, it is necessary to suppress the heat interference.

The measures against the self-generated heat or the heat interference described above are performed by blowing the air, disposing a heat sink, and arranging each component. On the other hand, the heat sink itself is large, and wiring for electrically connecting the components to each other is required, and thus, there is a problem in arranging the components compactly while performing sufficient thermal measures. This Example has been made in consideration of such circumstances, and the details thereof will be described below.

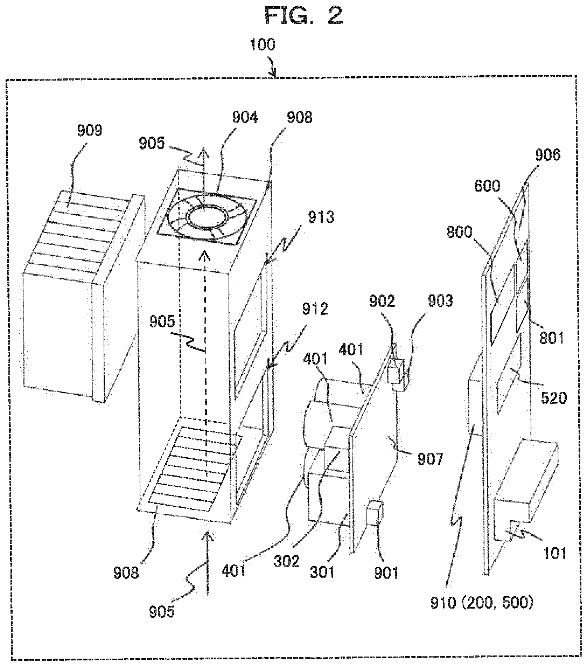

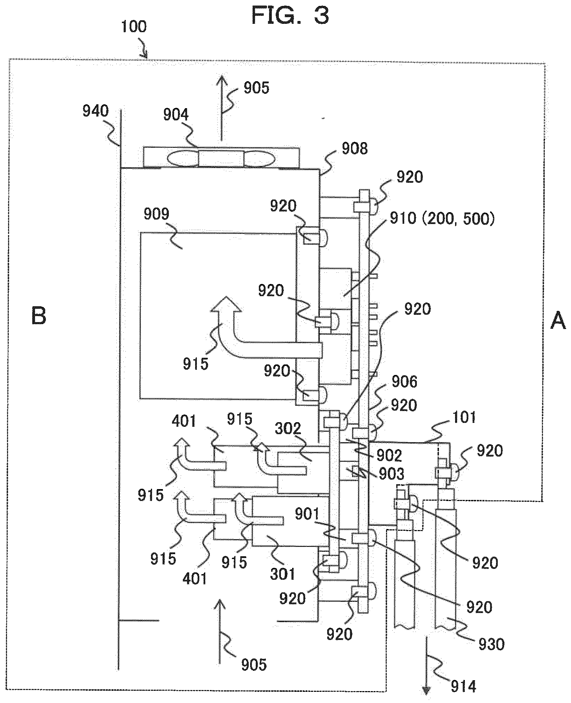

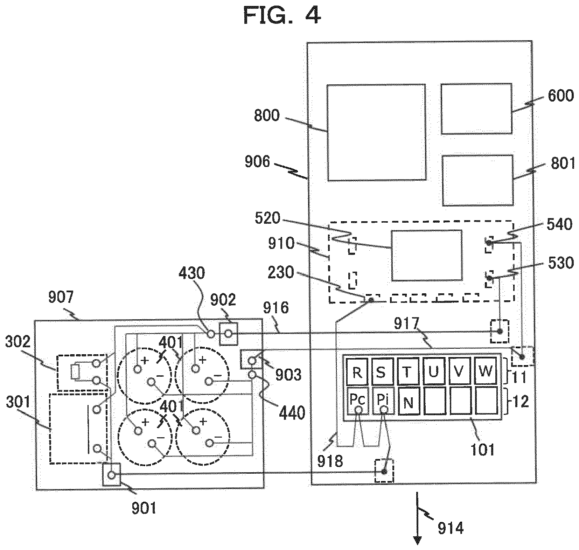

Fig. 2 is an exploded view of the power conversion device of Example 1. Fig. 3 is an internal configuration diagram when the power conversion device is seen from a lateral surface. Fig. 4 is a diagram illustrating a connection relationship between a first PCB board and a second PCB board of the power conversion device.

The power conversion device 100 will be described with reference to Fig. 2 to Fig. 4. The power conversion device 100 in Fig. 2 includes a fan 904, a first printed wiring board 906 (hereinafter, a printed wiring board is referred to as a PCB board (a printed circuit board)), a second PCB board 907, a main unit case 908, and a heat sink 909, in addition to the circuits and the components illustrated in Fig. 1.

The control circuit 800, the power source circuit 600, the voltage sensor 801, and the inverter drive circuit 520 are arranged on the first PCB board 906. The capacitor 401, the relay 301, the current-limiting resistance 302, and three terminal blocks 901 to 903 are arranged on the second PCB board 907.

The main unit case 908 includes the fan 904 in the upper portion, an arrangement hole 913 of a power module 910, the capacitor 401, the relay 301, an arrangement hole 912 of the current-limiting resistance 302 on the front surface, and a cooling air admission port in the lower portion. Fixtures such as bolts pass through installation holes provided on four corners of the back surface such that the power conversion device 100 is disposed on a wall surface. In the disposed state, the back surface of the power conversion device 100 is in contact with a disposition surface to be sealed. Bolts pass through fixing holes on four corners of a base plate of the heat sink 909 and fixing holes of the main unit case 908 to be fixed, and thus, the arrangement hole 913 is blocked.

Bolts passes through fixing holes on four corners of the second PCB board 907 and the fixing holes of the main unit case 908 to be fixed, and thus, the arrangement hole 912 is blocked. As described above, the heat sink 909 and the second PCB board 907 are assembled, and thus, the front surface of the main unit case is sealed.

A cooling structure of the power conversion device 100 of this Example will be described with reference to Fig. 3. In Fig. 3, A indicates the front side of the power conversion device 100, and B indicates the back side of the power conversion device 100.

In this example, the main unit case 908 is arranged to be in contact with an installation surface 940. As described above, since only the upper surface and the lower surface of the main unit case 908 are opened, cooling air 905 from the fan 904 is blown from the lower portion to the upper portion. The capacitor 401, the relay 301, and the current-limiting resistance 302 are directly exposed to the cooling air 905, and thus, heat 915 thereof is diffused to the cooling air 905.

Next, the cooling air 905 is blown to the heat sink 909, and thus, the heat 915 of the power module 910 attached to the heat sink 909, in which the converter circuit 200 and the inverter circuit 500 are built, is diffused to the cooling air 905. The cooling air 905 heated by the heat released from each of the components is exhausted outside the power conversion device 100 through the fan 904 attached to the upper portion of the main unit case 908, and thus, the cooling air that is constantly cool is supplied from the lower surface of the power conversion device 100.

The relay 301 is contained in the main unit case 908 and is forcedly air-cooled. Accordingly, cooling can be effectively performed compared to a case where the relay 301 is arranged on the first PCB board to which the cooling air does not flow. In particular, in a case where the plurality of relays 301 need to be connected to each other in parallel and the relays 301 need to be arranged close to each other, an effect of reducing the ambient temperature of the relay 301 is high, and the degeneration of a utilization rate is alleviated, and thus, it is effective for reducing the size of the relay 301 and the power conversion device 100.

Further, main heat-generating components of the power conversion device 100, such as the heat sink 909, the capacitor 401, and the relay 301, are contained in the main unit case 908, and thus, thermal insulation from the first PCB board can be enhanced. It is possible to suppress heat interference that is applied to the control circuit, the drive circuit, or the other electric circuit components (not illustrated), to be mounted on the first PCB board, and thus, it is effective for reducing the size of the power conversion device 100.

Among the components targeted in this Example, the heat generated from the power module 910 is maximized, and thus, an increase in the temperature of the cooling air is maximized before and after passing through the heat sink 909. Accordingly, the capacitor 401, the relay 301, and the current-limiting resistance 302 are arranged in the lower portion from the power module 910 and the heat sink 909, and thus, the capacitor 401 and the relay 301 can be effectively cooled compared to the case of the opposite arrangement. Then, it is possible to simplify an air blowing device such as the fan 904 or a circuit for driving the fan, and it is effective for reducing the size of the power conversion device 100.

In this Example, the fan 904 is arranged in the upper portion of the main unit case 908, but the fan 904 may be arranged in the lower portion of the main unit case 908, and the cooling air 905 may flow to the upper side from the lower side.

In addition, in this Example, the cooling air 905 flows to the upper side from the lower side, but the cooling air 905 may flow to the lower side from the upper side. In such a case, the capacitor 401, the relay 301, and the current-limiting resistance 302 are arranged in the upper portion from the heat sink 909.

That is, the cooling air from the fan is blown from the inrush prevention circuit 300 and the smoothing circuit 400 toward the heat sink, within the main unit case.

In addition, the fan 904 and the main unit case 908 may be arranged such that the cooling air 905 flows in a horizontal direction. Even in such a case, a positional relationship of the smoothing circuit 400 or the inrush prevention circuit 300 with respect to the power module 910 and the heat sink 909 is as described above.

Electric connection of each of the circuits will be described with reference to Fig. 4. As illustrated in Fig. 3, the first PCB board 906 is arranged on the front side of the power conversion device 100 with respect to the second PCB board 907, but Fig. 4 is a diagram when the first PCB board 906 and the second PCB board 907 are seen from the front surface of the power conversion device 100, respectively. Accordingly, in practice, wiring between the first PCB board 906 and the second PCB board 907 extends perpendicular to the plane of paper, but in Fig. 4, it is illustrated that the wiring is in a lateral direction on the plane of paper.

A positive electrode 530 of the inverter circuit 500 of the first PCB board 906 and a positive electrode 430 of the smoothing circuit 400 of the second PCB board 907 are electrically connected to each other through the terminal block 902. As illustrated by a solid line, it is preferable that wiring 916 is routed to be short.

The terminal block 903 electrically connects a negative electrode (not illustrated) of the converter circuit 200 and a negative electrode 540 of the inverter circuit 500, and a negative electrode 440 of the smoothing circuit 400 to each other. It is preferable to shorten the route of the wiring 916 and wiring 917 such that inductance parasitized in the wiring route decreases. In practice, the wiring 916 or the wiring 917 extends behind the plane of paper from the first PCB board 906, and thus, the wiring 916 or the wiring 917 can be shortened.

For example, in the power conversion device of this Example, the terminal blocks 902 and 903 are arranged on the upper-right side of the second PCB board 907 such that a distance between the inverter circuit 500 and he smoothing circuit 400 is minimized. Accordingly, the capacitor 401 and the terminal blocks 902 and 903 can be arranged close to each other.

Further, it is preferable to decrease an inductance component by arranging the wiring 916 and the wiring 917 to face each other between layers to be formed in the first PCB board 906 and the second PCB board 907. Accordingly, it is possible to decrease impedance between the wiring 916 and the wiring 917, which is proportionate to a route length, to suppress the loss of the switching element, and to suppress an increase in the temperature of the inverter circuit.

A collective terminal block 101 has a function of connecting a positive electrode 230 of the converter circuit 200 and the relay 301 to each other. The positive electrode 230 of the converter circuit 200 and the relay 301 are electrically connected to each other through a Pc terminal (a direct-current output terminal of a positive electrode) and a Pi terminal (a direct-current input terminal of the positive electrode) of the collective terminal block 101, and the terminal block 901 (a wiring route is illustrated by a solid line). Here, the collective terminal block 101 includes six terminals on the upper stage and at least three terminals on the lower stage. Here, the collective terminal block 101 includes two stages, but the collective terminal block 101 may include three or more stages. Accordingly, it is possible to shorten a width in the lateral direction and to attain the freedom degree of the arrangement of the circuit or compactification in the first PCB board 906.

Wiring 918 connects the positive electrode 230 of the converter circuit 200 and the Pc terminal of the collective terminal block 101 to each other. Since the wiring 918 is wiring to which the largest current flows in the power conversion device 100, it is preferable that the route of the wiring 918 is short. Accordingly, the relay 301 is arranged on the second PCB board.

According to such a configuration, the terminal block 901 to be connected to the relay 301 can be arranged in the vicinity of the Pi terminal of the collective terminal block 101. In Fig. 4, the terminal block 901 and the Pi terminal are illustrated in parallel to each other, but in practice, the terminal block 901 can be arranged behind the Pi terminal of the collective terminal block 101, and thus, the terminal block 901 can be arranged in the vicinity of the Pi terminal. Accordingly, Joule heat generated from the wiring decreases, and thus, it is effective for reducing the size of the power conversion device 100.

A configuration using the two-stage collective terminal block 101 has an advantage that a width dimension of the power conversion device 100 can be reduced compared to the case of one stage where the terminal blocks are arranged in a lateral row. A configuration in which the relay 301 is mounted on the second PCB board has an advantage that a vertical dimension of the power conversion device 100 can be reduced compared to a configuration in which the relay 301 is mounted on the first PCB board.

The collective terminal block 101 includes terminal blocks (R, S, T, U, V, and W) for connecting the three-phase alternating-current power source 701, the load 702, and the like and the power conversion device 100 to each other. Here, the R, S, and T terminals are a terminal for inputting a three-phase alternating-current, and the U, V, and W terminals are a terminal for outputting a three-phase alternating-current.

A high back component such as the relay 301 is not arranged in the lower portion of the collective terminal block 101, that is, the relay 301 is arranged on the second PCB board, and thus, a space can be provided in a drawing direction 914 of an electric wire 930. Accordingly, the electric wire 930 to be connected (by a harness or the like) to an external device can be easily connected to the collective terminal block 101.

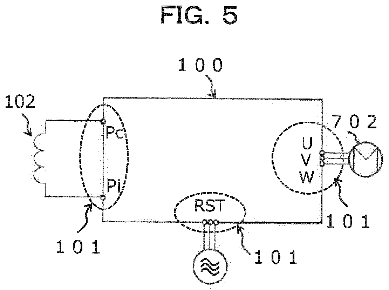

Fig. 5 is a circuit diagram illustrating a case in which a reactor 102 is connected to the collective terminal block 101 as an external additional circuit. By connecting the reactor 102 to the collective terminal block 101, an input power factor can be improved.

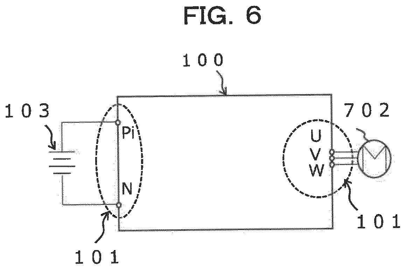

Fig. 6 is a circuit diagram illustrating a case in which an external direct-current power source 103 is connected to the collective terminal block 101. The Pi terminal is the direct-current input terminal of the positive electrode, and the N terminal is a direct-current terminal of a negative electrode. By connecting the direct-current power source 103 to the collective terminal block 101, it is possible to supply the direct-current electric power to the power conversion device 100 without driving the converter circuit 200.

In the configuration of two copper bars disclosed in Patent Document 1, the direct-current output (a positive electrode) of the forward converter and the input (a positive electrode) of the reverse converter are not capable of being externally connected to each other, and thus, there is a problem in providing an additional circuit outside the power conversion device or receiving the direct-current electric power. In this Example, such a problem can be avoided.

A wiring method of each of the R, S, T, U, V, and W terminals of the power module 910 and the collective terminal block 101 is arbitrary. For example, wiring such as providing copper wiring in the first PCB board may be performed by jumpering over the board with a copper wire or the like.

In Example 1, a configuration is exemplified in which four capacitors 401 are in parallel, but the number of parallels is arbitrary. In addition, the capacitors 401 may be connected to each other in series, and thus, resistance to a larger direct-current voltage may be provided. For example, an electrolytic capacitor, a film capacitor, and the like having a large capacity density and large capacity are preferable as the capacitor 401.

In Example 1, the converter circuit 200 is exemplified as the three-phase full-wave rectification circuit of the diode, but may be the other AC/DC conversion circuits.

In Example 1, the switching element is exemplified as an IGBT, but may be the other switching devices such as a metal-oxide-semiconductor field effect transistor (MOSFET). The material of the switching device is silicon (Si), silicon carbide (SiC), and the like.

In Example 1, the components described above are electrically connected to the board by soldering, or by using a fixture such as a bolt.

### REFERENCE SIGNS LIST

- 100: Power conversion device
- 101: Collective terminal block
- 102: Reactor
- 200: Converter circuit
- 300: Inrush prevention circuit
- 301: Relay
- 302: Current-limiting resistance
- 303: Relay drive circuit
- 400: Smoothing circuit
- 401: Capacitor

## Claims

1. A power conversion device, comprising:
an inverter circuit converting direct-current electric power into alternating-current electric power;
a heat sink cooling the inverter circuit;
an inrush prevention circuit suppressing an inrush current;
a smoothing circuit smoothing a voltage;
a first board on which the inverter circuit is arranged;
a second board on which the smoothing circuit and the inrush prevention circuit are arranged;
a main unit case accommodating the heat sink, the inrush prevention circuit, and the smoothing circuit; and
a fan blowing cooling air from the inrush prevention circuit and the smoothing circuit toward the heat sink within the main unit case.

2. The power conversion device according to claim 1,
wherein a control circuit is arranged on the first board, and
the smoothing circuit and the inrush prevention circuit are arranged under the heat sink.

3. The power conversion device according to claim 1,
wherein a plurality of stages of collective terminal blocks are arranged on the first board.

4. The power conversion device according to claim 1,
wherein a first terminal block to be connected to a positive electrode of the inverter circuit, and
a second terminal block to be connected to a negative electrode of the inverter circuit are arranged on the second board.

5. The power conversion device according to claim 4,
wherein the first terminal block connects a positive electrode of the smoothing circuit and the positive electrode of the inverter circuit to each other, and
the second terminal block connects a negative electrode of the smoothing circuit and the negative electrode of the inverter circuit to each other.

6. The power conversion device according to claim 3,
wherein the collective terminal block can be connected to a reactor.

7. The power conversion device according to claim 3,
wherein the collective terminal block can be connected to a direct-current power source.

8. The power conversion device according to claim 4,
wherein a converter circuit converting an alternating-current voltage into a direct-current voltage is arranged on the first board, and
a third terminal block to be connected to the inrush prevention circuit is provided on the second board.

9. The power conversion device according to claim 8,
wherein the first board is arranged on a front side of the second board,
the collective terminal block is connected to wiring to be connected to the positive electrode of the converter circuit and is arranged on the first board, and
the collective terminal block and the third terminal block are connected to each other.

10. The power conversion device according to claim 1,
wherein the collective terminal block to be connected to an external power source or a load is arranged on the first board, and
the first board is arranged on a front side from the second board.
